# EUROPEAN PATENT APPLICATION

(11) **EP 4 290 992 A1**
(43) Date of publication of application: **13.12.2023**
(21) Application number: 22194850.8
(22) Date of filing: 09.09.2022
(51) Int. Cl.: H05K 7/14

(54) **MODULAR DATA CENTER**

(30) Priority: 09.06.2022 US 202217836321
(71) Applicant: Google LLC, Mountain View, CA 94043 (US)
(72) Inventor: MAO, Liwen, Mountain View, 94043 (US); BOROWSKI, Joseph Arias, Mountain View, 94043 (US); MEAKINS, Michael Elery, Mountain View, 94043 (US); GAJARIA, Dhruv Dipak, Mountain View, 94043 (US); TEETZEL, Erik Christiansen, Mountain View, 94043 (US); JASTRZEBSKI, Mark Michal, Mountain View, 94043 (US); BENDER, Shawn Emory, Mountain View, 94043 (US)
(74) Representative: Betten & Resch

(57) **Abstract**

A method of outfitting a data center includes: identifying a footprint space for installing the data center; dividing the footprint space into a plurality of proper subsets; and identifying a set of data center modules for installation in the footprint space. The set of data center modules includes: a base data center module that includes components to establish a fully operational data center, the components including a first set of common components and a second set of unique components that are unique to the base data center module. The set of data center modules includes at least one auxiliary data center module that includes the first set of common components. The method includes installing the base data center module within a first proper subset of the footprint space; and installing an auxiliary data center module in at least one of the remaining proper subsets of the footprint space.

## Description

### TECHNICAL FIELD

This specification relates generally to data centers.

### BACKGROUND

Many data centers are not reconfigurable without redesigning the data center. Data centers may have various program areas, where components in each program area do not align with each other. Program areas can include, for example, mechanical yards, data halls, and electrical yards. In many cases, a data center has a fixed design. Due to the fixed design, it can be challenging to fit a data center in an existing shell and site with agnostic form factor.

### SUMMARY

In general, this disclosure relates to methods for outfitting scalable data centers. An example scalable data center includes a set of data center modules, including at least one base data center module and at least one auxiliary data center module.

Each data center module includes a set of common components. The set of common components can include, for example, a server hall, mechanical yard, and an electrical yard. Each data center module can be reconfigurable. For example, within a data center module, the arrangement of the server hall, mechanical yard, and electrical yard can be spatially arranged in different configurations.

Each data center includes at least one base data center module. In addition to the set of common components, the base data center module includes an additional set of unique components. For example, the base data center module can include a control room, a loading dock, and a main distribution area. The base data center module can also include a redundancy block including backup components such as a backup generator. The base data center module includes all components necessary to establish a fully operational data center.

Each data center may further include at least one auxiliary data center module. Auxiliary data center modules include the common set of components, and do not include the additional components of the base data center module. An auxiliary data center module need not include all components to establish a fully operational data center, but when combined with a base data center, results in a fully operational data center that is of greater operational capacity than the fully operational data center established by the base data center module alone.

Within a data center, the data center modules can have uniform configurations and can be installed such that the components of the data center modules align with each other. For example, a first data center module can be installed adjacent to a second data center module with the server hall, mechanical yard, and electrical yard of the first data center module aligning with the server hall, mechanical yard, and electrical yard of the second data center module. The data center modules include common electrical and mechanical connections. Therefore, electrical and mechanical systems of any data center module of a data center can be connected with any other data center module of the data center.

The scalable data centers can be adapted to footprints of various shapes and sizes. The data center modules can have varying sizes in length, width, height, and area. To outfit a data center within a footprint space, the footprint space can be divided into proper subsets by area. A base data center module can be installed in one of the proper subsets of the footprint space. An auxiliary data center module can be installed in each of the remaining proper subsets of the footprint space.

The data center modules are the smallest units of the data center. Therefore, the data center can be scaled up in size by adding a data center module. Similarly, the data center can be scaled down in size by removing a data center module.

The disclosed systems and techniques can be used to outfit data centers quickly and easily in locations that were not designed for housing data centers. For example, a warehouse can be retrofitted to house a data center.

In general, one innovative aspect of the subject matter described in this specification can be embodied in a method of outfitting a data center. The method includes identifying a footprint space for installing the data center; dividing the footprint space into a plurality of proper subsets; and identifying a set of data center modules for installation in the footprint space. The set of data center modules includes: a base data center module that includes components to establish a fully operational data center, the components including a first set of common components and a second set of unique components that are unique to the base data center module. The first set of common components and the second set of unique components establish a fully operational data center. The set of data center modules includes at least one auxiliary data center module that includes the first set of common components. The method includes installing the base data center module within a first proper subset of the footprint space, including deploying the first set of common components and the second set of unique components of the base data center module in an operational state; and installing an auxiliary data center module in at least one of the remaining proper subsets of the footprint space, including deploying the set of common components of the auxiliary data center module interconnected with the first set of common components and the second set of unique components of the base data center module in an operational state.

The foregoing and other embodiments can each optionally include one or more of the following features, alone or in combination. In some implementations, the method includes installing the set of data center modules with the set of common components of each data center module in alignment with the set of common components of each other data center module.

In some implementations, deploying the set of common components includes deploying a server hall, an indoor mechanical, electrical, plumbing (MEP) room, and an outdoor MEP yard.

In some implementations, deploying the server hall includes deploying a plurality of server computers arranged in server racks.

In some implementations, deploying the indoor MEP room includes deploying mechanical, electrical, and plumbing components of the data center in an operational state in an indoor location of the footprint space.

In some implementations, deploying the outdoor MEP yard includes deploying mechanical, electrical, structural, and plumbing components of the data center in an operational state in an outdoor location of the footprint space.

In some implementations, deploying the second set of unique components includes deploying at least one of a control room, a loading dock, a main distribution area, or a backup power supply.

In some implementations, the method includes increasing operational capacity of the data center by installing at least one additional auxiliary data center module in one of the remaining proper subsets of the footprint space, including deploying the set of common components of the auxiliary data center interconnected with the first set of common components and the second set of unique components of the base data center module in an operational state.

In some implementations, the method includes decreasing operational capacity of the data center by removing at least one of the auxiliary data center modules from the footprint space.

In some implementations, the at least one auxiliary data center module are uniform in operational capacity.

In some implementations, the plurality of proper subsets are uniform in area.

In general, one innovative aspect of the subject matter described in this specification can be embodied in a data center outfitted within a footprint space including a plurality of proper subsets of the footprint space. The data center includes a set of data center modules, the set of data center modules including: a base data center module installed within a first proper subset of the footprint space, the base data center module including a components to establish a fully operational data center, the components including a first set of common components and a second set of unique components that are unique to the base data center module. The first set of common components and the second set of unique components establish a fully operational data center. The data center includes an auxiliary data center module installed in at least one of the remaining proper subsets of the footprint space, the auxiliary data center module including the set of common components. The set of common components of the auxiliary data center is interconnected with the first set of common components and the second set of unique components of the base data center module in an operational state.

The foregoing and other embodiments can each optionally include one or more of the following features, alone or in combination. In some implementations, the set of data center modules is installed with the first set of common components of each data center module in alignment with the set of common components of each other data center module.

In some implementations, the set of common components includes a server hall, an indoor mechanical, electrical, plumbing (MEP) room, and an outdoor MEP yard.

In some implementations, the server hall includes a plurality of server computers arranged in server racks.

In some implementations, the indoor MEP room includes mechanical, electrical, and plumbing components of the data center installed in an indoor location of the footprint space.

In some implementations, the outdoor MEP yard includes mechanical, electrical, structural, and plumbing components of the data center installed in an outdoor location of the footprint space.

In some implementations, the second set of unique components includes at least one of a control room, a loading dock, a main distribution area, or a backup power supply.

In some implementations, the set of data center modules includes a plurality of auxiliary data center modules that are uniform in operational capacity.

In some implementations, the plurality of proper subsets are uniform in area.

The disclosed techniques can be implemented to provide the following advantages. The use of predefined configurations can improve speed and efficiency of planning, design, and construction of a data center. A modular data center can be built in repeatable increments in a linear pattern. Thus, inter-program area interface management can be simplified. Data center modules can be added or removed to increase or decrease data center capacity incrementally, while reducing disruption to operations of the data center. The disclosed techniques can be used to retrofit existing structures. Thus, data centers can be deployed in previously unsuitable locations. The disclosed techniques are adaptive, permitting the use of various data center module sizes to fit the available size and shape of available space.

The details of one or more embodiments of the subject matter of this specification are set forth in the accompanying drawings and the description below. Other features, aspects, and advantages of the subject matter will become apparent from the description, the drawings, and the claims.

### BRIEF DESCRIPTION OF THE DRAWINGS

FIG. 1 illustrates an example auxiliary data center module.
FIG. 2 illustrates an example layout of a modular data center.
FIG. 3 illustrates example interconnections between data center modules.
FIG. 4A illustrates an example footprint space of a data center.
FIG. 4B illustrates an example arrangement of data center modules in a footprint space.
FIGS. 5A to 5C illustrate example data center modules.
FIG. 6 is a flow diagram of an example process for outfitting a modular data center.

Like reference numbers and designations in the various drawings indicate like elements.

### DETAILED DESCRIPTION

An example scalable data center includes a set of data center modules, including at least one base data center module and at least one auxiliary data center module. Each data center module includes a set of common components. The set of common components can include, for example, a server hall, mechanical yard, and an electrical yard.

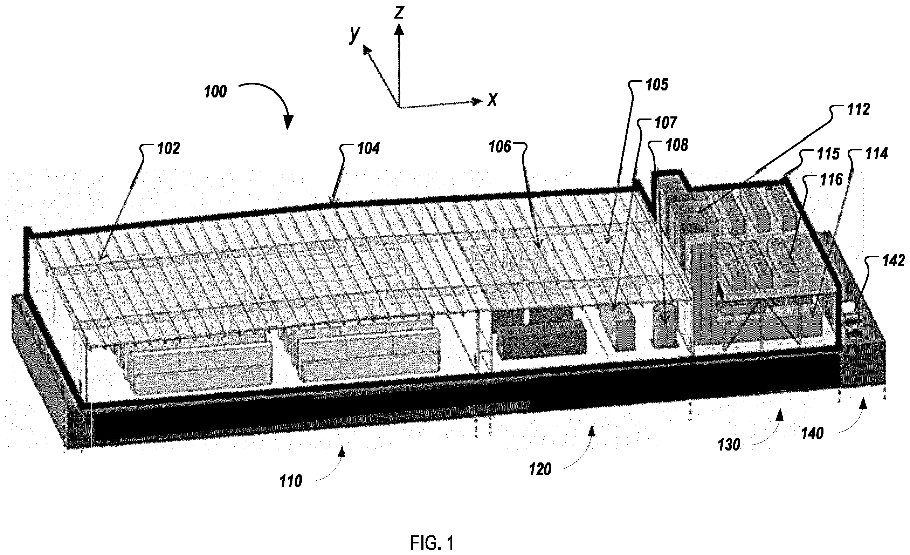

FIG. 1 illustrates an example auxiliary data center module 100. The example auxiliary data center module 100 has a capacity of 11 megawatts (MW). The auxiliary data center module includes the set of common components, including a server hall 110, an indoor mechanical, electrical, plumbing (MEP) room 120, and an outdoor MEP yard 130. The auxiliary data center module 100 has a width in the y-direction, a length in the x-direction, and a height in the z-direction. Interconnections between the auxiliary data center module 100 and other data center modules are generally made along the length of the auxiliary data center module 100.

The server hall 110 houses rows of server computers arranged in server racks 102. The server racks 102 can be arranged in rows under a shell 104. In some examples, the shell 104 can be an installed component of the data center module. In some examples, the shell 104 is a pre-existing structure within the footprint space. For example, the shell 104 can be a roof of a building within the footprint space.

The indoor MEP room 120 includes mechanical, electrical, and plumbing components of the data center. The indoor MEP room 120 is an indoor location of the footprint space. The indoor MEP room 120 houses a Power Modular Distribution Center (PMDC) skid 106, a power distribution center (PDC) skid 105, an air cooled chiller plant (APC) skid 107, and a buffer vessel 108.

The outdoor MEP yard 130 includes mechanical, electrical, structural, and plumbing components of the data center in an outdoor location of the footprint space. The outdoor MEP yard 130 houses a set of critical generators 112 and a mechanical generator 114. The outdoor MEP yard 130 also houses a set of air cooled chillers 116 stacked on a gantry 115. Available outdoor space can be increased by stacking components above and below the gantry 115.

The auxiliary data center module 100 need not include all components to establish a fully operational data center. When installed and interconnected with a base data center, the result is a fully operational data center that is of greater operational capacity than the fully operational data center established by the base data center module alone. The auxiliary data center module 100 is self-supportive, such that the equipment of the indoor MEP room 120 and the outdoor MEP yard 130 provides the necessary support systems for the server hall 110.

Auxiliary data center module 100 can be reconfigurable. For example, each of the server hall 110, indoor MEP room 120, and outdoor MEP yard 130 can have multiple configurations within the same boundary of the auxiliary data center module 100. For example, the arrangement of chillers, conditioners, and battery backups within an MEP yard may vary between one auxiliary data center module 100 and another auxiliary data center module.

The auxiliary data center module 100 is installed adjacent to a road 140. The road 140 provides vehicle access to the auxiliary data center module 100. An example vehicle 142 is shown in FIG. 1.

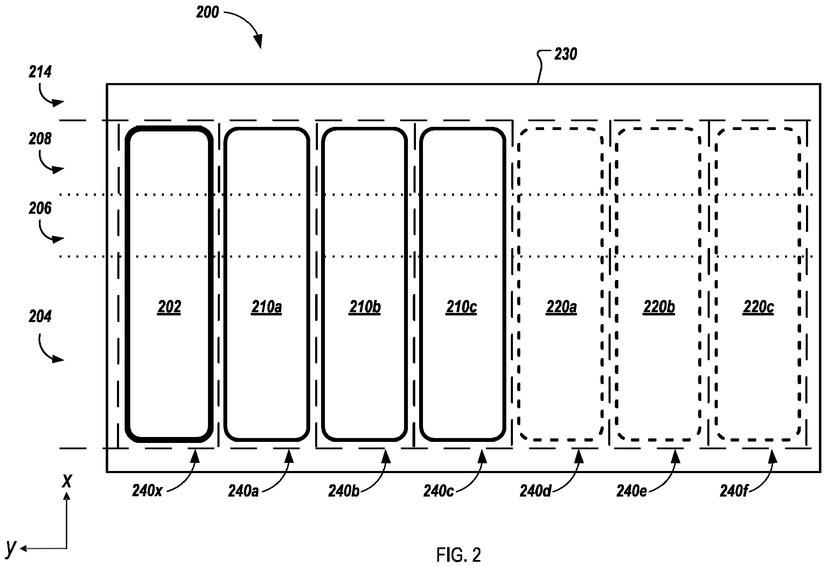

FIG. 2 illustrates an example layout of a modular data center 200. FIG. 2 shows an overhead view of the modular data center 200. The modular data center 200 includes a set of data center modules including base data center module 202 and auxiliary data center modules 210a-c. The set of data center modules are arranged with the length dimension (x-direction) of each data center module being parallel to the length dimension of each other data center module. Space is available to add additional auxiliary data center modules 220a-c.

To install a data center within a footprint space, e.g., footprint space 230, the footprint space can be divided into proper subsets by area. A base data center module, e.g., base data center module 202, can be installed in one of the proper subsets of the footprint space. An auxiliary data center module, e.g., auxiliary data center modules 210a-c, can be installed in each of the remaining proper subsets of the footprint space.

As shown in FIG. 2, each data center module of the set of data center modules is installed in a proper subset of a footprint space 230. For example, the footprint space 230 is divided into proper subsets 240x and 240a-f. Base data center module 202 is installed in proper subset 240x. Auxiliary data center modules 210a-c are installed in proper subsets 240a-c, respectively. Additional auxiliary data center modules 220a-c can be installed in proper subsets 240d-f, respectively. The additional auxiliary data center modules 220a-c can be added incrementally. For example, additional auxiliary data center module 220a can be installed in proper subset 240d to add capacity to the data center 200, prior to adding additional data center module 220b or 220c.

In some examples, the auxiliary data center modules 210a-c can be interchangeable, such that any of the auxiliary data center modules 210a-c can be installed in any of the proper subsets 240a-f. Similarly, to add capacity to the data center 200, any of the additional auxiliary data center modules 220a-c can be installed in any of the proper subsets 240d-f.

The base data center module 202 includes a set of unique components that are unique to the base data center module. The set of unique components can include, for example, a control room, a loading dock, a main distribution area, and backup equipment, such as a backup power supply. The base data center module 202 can also include the set of common components, e.g., a server hall, an indoor MEP room, and an outdoor MEP yard. The set of unique components and the set of common components of the base data center module 202 are sufficient to establish a fully operational data center. In some implementations, one base data center module 202 can support an unlimited number of auxiliary data center modules 210. In other implementation, one base data center module can support a limited number of auxiliary data center modules 210, e.g., N base data center modules.

In some examples, auxiliary data center modules within the data center 200 can have different operational capacities from each other. For example, auxiliary data center module 210a may have a capacity of 11MW, while auxiliary data center module 210b has a capacity of 12MW, and auxiliary data center module 210c has a capacity of 13MW. In some examples, auxiliary data center modules within the data center 200 can be uniform in operational capacity. For example, auxiliary data center module 210a, 210b, and 210c can each have a capacity of 10MW.

In some examples, a data center module is the smallest unit of the data center 200. The data center 200 can be scaled up in size and capacity by adding one or more auxiliary data center modules, e.g., by adding any of the additional data center modules 220a-c. For example, the base data center module 202 and each of the auxiliary data center modules 210a-c may have a capacity of 10MW. The capacity of the data center 200 can be increased from 40MW to 50MW by adding the additional auxiliary data center module 220a, having a capacity of 10MW. The additional auxiliary data center module 220a can be added to the data center 200 by installing the additional auxiliary data center module 220a in the footprint space 240d and deploying the set of common components of the auxiliary data center module 220a interconnected with the set of common components of the base data center module 202 and the set of unique components of the base data center module 202. In some examples, the common components of the auxiliary data center module 220 interconnect with the components of the base data center module 202 through components of intermediate data center modules, e.g., auxiliary data center modules 210a-c.

Similarly, the data center 200 can be scaled down in size and capacity by removing one or more auxiliary data center modules, e.g., by removing any of auxiliary data center modules 210a-c. For example, the capacity of the data center 200 can be reduced from 40MW to 30MW by removing the auxiliary data center module 210c, having a capacity of 10MW. The auxiliary data center module 210c can be removed from the data center 200 by disconnecting the common components of the auxiliary data center module 210c from the common components of the base data center module 202 and from the unique components of the base data center module 202.

The common components of the data center modules align with each other, permitting the addition, removal, or replacement of data center modules without disrupting the arrangement of other data center modules. For example, server halls 204 of the base data center module 202 and of the auxiliary data center modules 210a-c are aligned in the horizontal y-direction. Similarly, indoor MEP rooms 206 and the outdoor MEP yards 208 are aligned in the y-direction. A road 214 passes adjacent to the outdoor MEP yards 208 of the data center modules.

Each data center module can be reconfigurable. For example, within a particular data center module, the components within each of the server hall, mechanical yard, and electrical yard can be spatially arranged in different configurations. In an example, the arrangement of server racks in rows in the server hall may be different for the auxiliary data center module 210a than for the auxiliary data center module 210b.

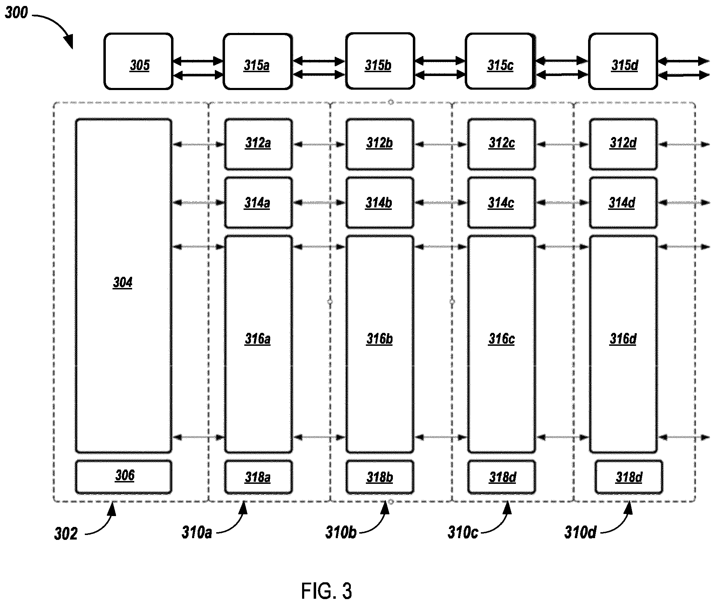

FIG. 3 illustrates example interconnections between data center modules. FIG. 3 shows an example data center 300 including base data center module 302 and auxiliary data center modules 310a-d. Base data center module 302 includes buffer 306 and an outdoor MEP yard 305.

The auxiliary data center modules 310a-d include server halls 316a-d, electrical areas 314a-d, and mechanical areas 312a-d, respectively. The auxiliary data center modules 310a-d also include buffers 318a-d and outdoor MEP yards 315a-d, respectively. The buffers 306 and 318a-d can include non-critical buffer space on the edges of the foot print space that absorbs irregularity in the shape of the footprint space.

The auxiliary data center modules 310a-d are installed with the set of common components of each data center module in alignment with the set of common components of each other data center module. For example, the electrical area 314b of the auxiliary data center module 310b is in alignment with the electrical area 314c of the auxiliary data center module 310c.

To deploy the data center modules in an operational state, connections can be made between the data center modules. The data center modules can include standard connections, such that any data center module can connect with any other data center module. Connections between data center modules can include, for example, connections for electrical power systems, mechanical systems, telecommunications, water cooling systems, air cooling systems, control systems, fire protection, or any combination of these. To install the auxiliary data center module 310a, the set of common components of the auxiliary data center module 310 is interconnected with the set of common components of the base data center module 302 and the set of unique components of the base data center module 302 in an operational state. In an operational state, the data center 300 is a fully functioning data center.

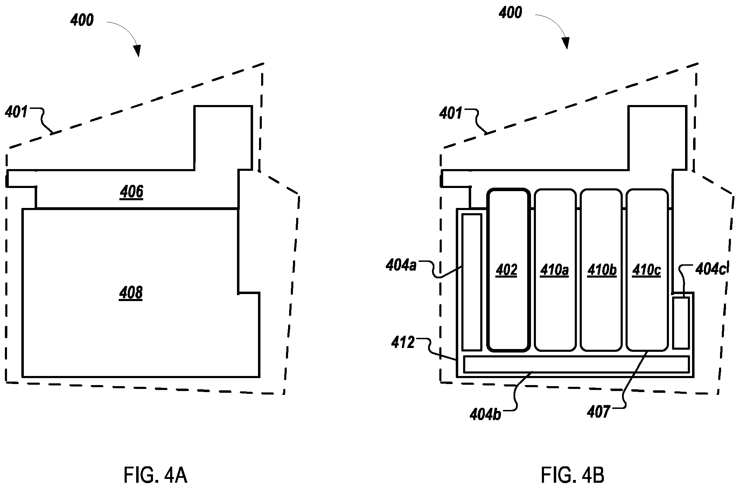

FIG. 4A illustrates an example footprint space 400 of a data center. The footprint space 400 can be an area of land that has been identified for outfitting a data center. The footprint space 400 has a boundary 401.

The footprint space 400 includes a shell area 408 and a pavement area 406. The shell area 408 can be, for example, an area within a building or other structure. The pavement area 406 can be an area that is accessible by motor vehicle, e.g., including a road, parking lot, or other paved area. In an example scenario, the footprint space 400 is an area of land where a warehouse was built, the shell area 408 includes the warehouse building, and the pavement area 406 includes a parking lot and driveway that connects the warehouse to a road.

Data center modules, including base data center modules and auxiliary data center modules, can be selected for deployment within the footprint space 400 based on various criteria. For example, data center modules can be selected based on the size and shape of the data center modules, and the size and shape of the footprint space. In some examples, data center modules can be selected to optimize the usage of space within the shell area 408. Data center modules can also be selected based on technological requirements for the data center.

FIG. 4B illustrates an example arrangement of data center modules in a data center. Once data center modules have been selected, the data center modules can be outfitted within the footprint space to form an operational data center. To outfit the footprint space 400 with a data center, the footprint space 400 can be divided into proper subsets. Example proper subsets of a footprint space were described with reference to FIG. 2.

In some examples, as in FIG. 4A, the footprint space 400 has an irregular shape. For an irregular shaped footprint space, the base data center module can be deployed to a proper subset within the most regularly-shaped region of the footprint space. For example, referring to FIG. 4B, the base data center module 402 is assigned to a location near a rectangular corner 412 of the shell area 408.

Once the location of the base data center module 402 is determined, the auxiliary data center modules 410a-c can be assigned to locations within the footprint space. Components of the data center modules can then be ordered and shipped to the data center. In some examples, some elements of the data center modules can be pre-fabricated at another site before delivery to the footprint space 400. In some examples, equipment needed for constructing the data center can be delivered to the footprint space 400, and assembled on-site.

Each of the auxiliary data center modules 410a-c is installed in a proper subset within the footprint space 400. The common components of each auxiliary data center module can be aligned with the common components of adjacent auxiliary data center modules and with the common components of the base data center module.

In some cases, extra space is available in the footprint space after the locations of the data center modules have been allocated. For example, referring to FIG. 4B, extra space exist between the data center modules and the boundary of the shell area 408. Buffer spaces, e.g., buffer spaces 404a-c can be allocated to this extra space. Buffer spaces 404a-c can include, for example, office space, storage space, or corridor space. Buffer spaces can thus be used to absorb extra area of a regular or irregular footprint space.

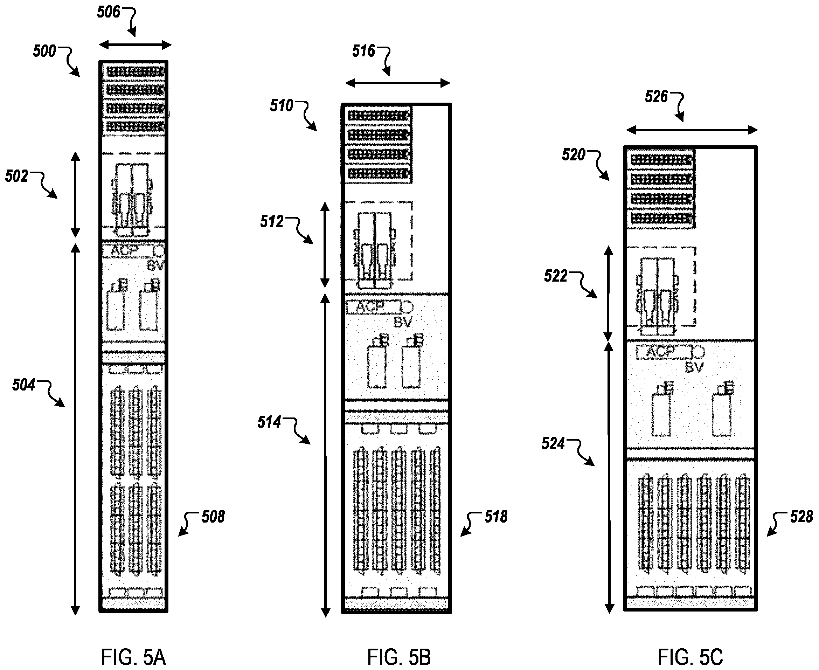

FIGS. 5A to 5C illustrate example auxiliary data center modules 500, 510, 520, respectively. Auxiliary data center modules 500, 510, 520 each have the same capacity, but have different sizes by area. For example, each auxiliary data center module 500, 510, 520 may have a capacity of 3.7MW IT load, 1.14MW mechanical load, and 4.84MW total load.

FIG. 5A shows an example auxiliary data center module 500. The auxiliary data center module 500 has a width 506 of 16.6 meters (m), an indoor length 504 of 96m, and an outdoor length 502 of 24.8m. The server hall 508 of the auxiliary data center module 500 includes six server rows.

FIG. 5B shows an example auxiliary data center module 510. The auxiliary data center module 510 has a width 516 of 24m, an indoor length 514 of 78m, and an outdoor length 512 of 24.8m. The server hall 518 of the auxiliary data center module 510 includes nine server rows.

FIG. 5C shows an example auxiliary data center module 520. The auxiliary data center module 520 has a width 526 of 31.7m, an indoor length 524 of 66.5m, and an outdoor length 522 of 24.8m. The server hall 528 of the auxiliary data center module 520 includes twelve server rows.

For a data center that has a need for an auxiliary data center module with a capacity of 3.7MW IT load, 1.14MW mechanical load, and 4.84MW total load, any of the auxiliary data center modules 500, 510, 520, can be used. Due to the differing arrangements of server rows, the areas of the auxiliary data center modules are different from each other, though their capacities are the same. A particular auxiliary data center module can be selected based on the size and shape of the footprint space to be outfitted with the data center. In some examples, a data center can include a combination of auxiliary data centers having different sizes, shapes, and capacities.

Using data center modules of different sizes, data centers can be adapted to footprints of various shapes and sizes. The data center modules can have varying sizes as measured in meters (m). Example data center modules can have width and length dimensions, of, for example, 45m by 121m, 36m by 160m, and 45m by 150m.

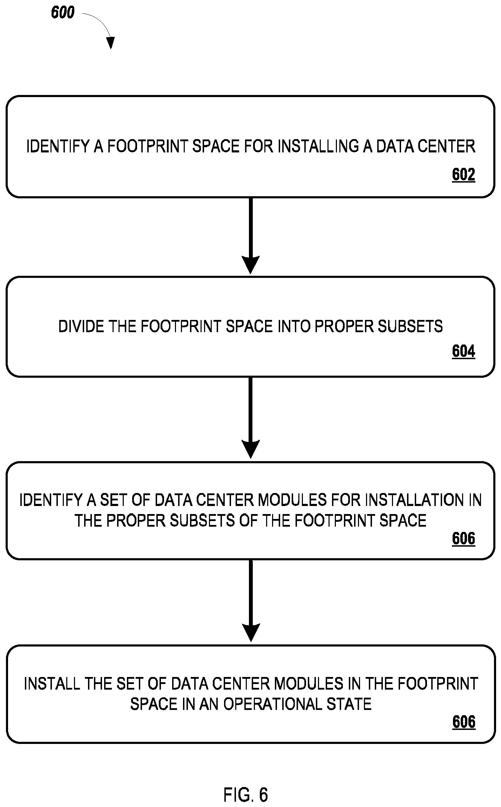

FIG. 6 is a flow diagram of an example process 600 for outfitting a modular data center. The process 600 includes identifying a footprint space for outfitting a data center (602). For example, referring to FIG. 2, the footprint space 230 can be identified for outfitting a data center.

The process 600 includes dividing the footprint space into proper subsets (604). For example, referring to FIG. 2, the footprint space 230 can be divided into proper subsets 240x, 240a-f. Each proper subset is an area that is contained inside the footprint space. In some examples, the proper subsets are uniform in size, shape, area, or any of these. In some examples, the proper subsets are non-uniform in size, shape, area, or any of these.

The process 600 includes identifying a set of data center modules for installation in the proper subsets of the footprint space (606). For example, referring to FIG. 2, the set of data center modules includes base data center module 202 and auxiliary data center modules 210a-c. The base data center module 202 is identified for installation in proper subset 240x of the footprint space 230. The auxiliary data center modules 210a-c are identified for installation in subsets 240a-c of the footprint space 230. The subsets 240d-f are available for installation of any of additional auxiliary data center modules 220a-c.

The process 600 includes installing the set of data center modules in the footprint space in an operational state (608). For example, referring to FIG. 2, the base data center module is installed within the proper subset 240x of the footprint space 230 in an operational state. The auxiliary data center modules 210a-c are installed within the proper subsets 240a-c of the footprint space 230. The auxiliary data center modules 210a-c are deployed interconnected with the components of the base data center module 202.

According to another aspect, there is disclosed a method of outfitting a data center, including: identifying a footprint space for installing the data center; dividing the footprint space into a plurality of proper subsets; and identifying a set of data center modules for installation in the footprint space. The set of data center modules includes: a base data center module that includes components to establish a fully operational data center, the components including a first set of common components and a second set of unique components that are unique to the base data center module. The set of data center modules includes at least one auxiliary data center module that includes the first set of common components. The method includes installing the base data center module within a first proper subset of the footprint space; and installing an auxiliary data center module in at least one of the remaining proper subsets of the footprint space.

While this specification contains many specific implementation details, these should not be construed as limitations on the scope of what may be claimed, but rather as descriptions of features that may be specific to particular embodiments. Certain features that are described in this specification in the context of separate embodiments can also be implemented in combination in a single embodiment. Conversely, various features that are described in the context of a single embodiment can also be implemented in multiple embodiments separately or in any suitable subcombination. Moreover, although features may be described above as acting in certain combinations and even initially claimed as such, one or more features from a claimed combination can in some cases be excised from the combination, and the claimed combination may be directed to a subcombination or variation of a subcombination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system modules and components in the embodiments described above should not be understood as requiring such separation in all embodiments, and it should be understood that the described program components and systems can generally be integrated together in a single software product or packaged into multiple software products.

Particular embodiments of the subject matter have been described. Other embodiments are within the scope of the following claims. For example, the actions recited in the claims can be performed in a different order and still achieve desirable results. As one example, the processes depicted in the accompanying figures do not necessarily require the particular order shown, or sequential order, to achieve desirable results. In some cases, multitasking and parallel processing may be advantageous.

## Claims

1. A method of outfitting a data center comprising:
identifying a footprint space for installing the data center;
dividing the footprint space into a plurality of proper subsets;
identifying a set of data center modules for installation in the footprint space, the set of data center modules including:
a base data center module that includes components to establish a fully operational data center, the components including a first set of common components and a second set of unique components that are unique to the base data center module, and wherein the first set of common components and the second set of unique components establish a fully operational data center; and
at least one auxiliary data center module that includes the first set of common components;
installing the base data center module within a first proper subset of the footprint space, including deploying the first set of common components and the second set of unique components of the base data center module in an operational state; and
installing an auxiliary data center module in at least one of the remaining proper subsets of the footprint space, including deploying the set of common components of the auxiliary data center module interconnected with the first set of common components and the second set of unique components of the base data center module in an operational state.

2. The method of claim 1, comprising installing the set of data center modules with the set of common components of each data center module in alignment with the set of common components of each other data center module, and/or,
wherein deploying the set of common components comprises deploying a server hall, an indoor mechanical, electrical, plumbing (MEP) room, and an outdoor MEP yard.

3. The method of claim 2, wherein deploying the server hall comprises deploying a plurality of server computers arranged in server racks.

4. The method of claim 2 or 3, wherein deploying the indoor MEP room comprises deploying mechanical, electrical, and plumbing components of the data center in an operational state in an indoor location of the footprint space, or,
wherein deploying the outdoor MEP yard comprises deploying mechanical, electrical, structural, and plumbing components of the data center in an operational state in an outdoor location of the footprint space.

5. The method of any one of claims 1 to 4, wherein deploying the second set of unique components comprises deploying at least one of a control room, a loading dock, a main distribution area, or a backup power supply.

6. The method of any one of claims 1 to 5, comprising increasing operational capacity of the data center by installing at least one additional auxiliary data center module in one of the remaining proper subsets of the footprint space, including deploying the set of common components of the auxiliary data center interconnected with the first set of common components and the second set of unique components of the base data center module in an operational state.

7. The method of any one of claims 1 to 6, comprising decreasing operational capacity of the data center by removing at least one of the auxiliary data center modules from the footprint space.

8. The method of any one of claims 1 to 7, wherein the at least one auxiliary data center module are uniform in operational capacity, and/or,
wherein the plurality of proper subsets are uniform in area.

9. A data center outfitted within a footprint space including a plurality of proper subsets of the footprint space, the data center comprising a set of data center modules, the set of data center modules including:
a base data center module installed within a first proper subset of the footprint space, the base data center module including a components to establish a fully operational data center, the components including a first set of common components and a second set of unique components that are unique to the base data center module, and wherein the first set of common components and the second set of unique components establish a fully operational data center; and
an auxiliary data center module installed in at least one of the remaining proper subsets of the footprint space, the auxiliary data center module including the set of common components, wherein the set of common components of the auxiliary data center is interconnected with the first set of common components and the second set of unique components of the base data center module in an operational state.

10. The data center of claim 9, wherein the set of data center modules is installed with the first set of common components of each data center module in alignment with the set of common components of each other data center module.

11. The data center of claim 9 or 10, wherein the set of common components comprises a server hall, an indoor mechanical, electrical, plumbing (MEP) room, and an outdoor MEP yard, and, wherein optionally the server hall comprises a plurality of server computers arranged in server racks.

12. The data center of claim 11, wherein the indoor MEP room comprises mechanical, electrical, and plumbing components of the data center installed in an indoor location of the footprint space.

13. The data center of claim 11 or 12, wherein the outdoor MEP yard comprises mechanical, electrical, structural, and plumbing components of the data center installed in an outdoor location of the footprint space.

14. The data center of any one of claims 9 to 13, wherein the second set of unique components comprises at least one of a control room, a loading dock, a main distribution area, or a backup power supply, and/or,
wherein the set of data center modules includes a plurality of auxiliary data center modules that are uniform in operational capacity.

15. The data center of any one of claims 9 to 14, wherein the plurality of proper subsets are uniform in area.
